Europäisches Patentamt

European Patent Office

Office européen des brevets

(11) Veröffentlichungsnummer : **0 043 084**
**B1**

(19)

(12) **EUROPÄISCHE PATENTSCHRIFT**

(45) Veröffentlichungstag der Patentschrift :
**15.05.85**

(21) Anmeldenummer : **81104846.1**

(22) Anmeldetag : **23.06.81**

(51) Int. Cl.⁴ : **G 03 G   5/06**, G 03 F   7/10,
C 08 L 25/04, C 08 L 31/04,
C 08 L 33/08, H 05 K   3/02

(54) Flexible, laminierbare lichtempfindliche Schicht.

(30) Priorität : **30.06.80 DE 3024772**

(43) Veröffentlichungstag der Anmeldung :
**06.01.82 Patentblatt 82/01**

(45) Bekanntmachung des Hinweises auf die Patenterteilung : **15.05.85 Patentblatt 85/20**

(84) Benannte Vertragsstaaten :
**AT BE CH DE FR GB IT LI NL SE**

(56) Entgegenhaltungen :
**DE-A- 2 306 982**
**DE-A- 2 755 851**

(73) Patentinhaber : **HOECHST AKTIENGESELLSCHAFT**
**Postfach 80 03 20**
**D-6230 Frankfurt am Main 80 (DE)**

(72) Erfinder : **Brechlin, Alfred, Dr.**
**Am Hohen Stein 20**
**D-6200 Wiesbaden (DE)**

**Beschreibung**

Die Erfindung betrifft eine flexible, laminierbare lichtempfindliche Schicht mit einem polymeren Bindemittel auf vorzugsweise flexiblem Träger.

Es ist bekannt, zur Herstellung von kopierten Schaltungen (DE-AS 20 64 080) lichtempfindliche Gemische in Form fester Schichten zu verwenden, die photopolymerisierbare Kopiermassen darstellen und auf einem metallischen Träger oder auf einem Zwischenträger aus Kunststoffolie vorliegen. Sie werden an den von Licht getroffenen Stellen unlöslich. Die nicht vom Licht getroffenen Stellen lassen sich nach dem Belichten durch wäßrig-alkalische Lösungen weglösen. Als Bindemittel verwendet man Mischpolymerisate aus Methacrylsäure und mindestens einem Alkylmethacrylat, worin mindestens eines der Alkylmethacrylate eine Alkylgruppe mit 4-15 Kohlenstoffatomen enthält. Die Elastizität solcher Schichten muß durch Zusatz von Weichmacher eingestellt werden. Außerdem ist die Herstellung kopierter Schaltungen an ein Verfahren gebunden, das wegen der Photopolymerisation eine unerwünscht große Energiezufuhr notwendig macht.

Es sind jedoch auch Verfahren bekannt, die geringere Lichtenergien zur Herstellung von Druckformen und gedruckten Schaltungen benötigen. Hierzu gehört das elektrophotographische Verfahren. Es sind verschiedene elektrophotographische Schichten beschrieben, die für die Herstellung solcher Artikel geeignet sind. Sie bestehen zum Beispiel aus einem photoleitfähigen, mehrkernigen, carbocyclischen Aromaten als Photoleiter und werden zusammen mit einem Aktivator und Bindemitteln, wie ein Terpolymer aus 60 % Methacrylsäure-n-hexylester, 10 % Styrol und 30 % Methacrylsäure (DE-OS 27 55 851), eingesetzt. Die Schicht wird in gelöster Form auf den Druckplattenträger aufgebracht und das Lösemittel verdampft. Schichten dieser Art genügen jedoch noch nicht bezüglich der Flexibilität bzw. Elastizität höchsten Ansprüchen, wenn der Träger flexibel oder elastisch ist, und bieten auch für die Aufbringung auf einen Zwischenträger keine so gute Haftung, insbesondere wenn die Trägerfolie gebogen oder gerollt wird.

Es ist zur Herstellung von Druckformen und gedruckten Schaltungen auf elektrophotographischem Wege auch bekannt, als Bindemittel ein Mischpolymerisat aus Styrol und Maleinsäureanhydrid einzusetzen (DE-OS 27 26 116 und 25 26 720). Das Bindemittel bildet jedoch in der beschriebenen Dicke von 5 μm auf flexiblem Trägermaterial lediglich eine nicht so gut haftende spröde Schicht, die sich nur schwer unter Anwendung höherer Temperaturen und Druck übertragen läßt. Bei diesen Temperaturen beginnen sich als Träger verwendete Polyesterfolien zu verziehen, was zu Streifenbildungen und Dickenunterschieden der übertragenen Schichten führt, die unerwünscht sind. Auch kann man solche übertragenen Schichten nur schwer in wäßrig-alkalischen Lösungen in einem späteren Verfahrensschritt entschichten.

Zur Herstellung von elektrophotographischem Aufzeichnungsmaterial ist es auch bekannt (DE-A-23 06 982), auf dem Trägermaterial eine photoleitfähige Schicht zu verwenden, die substituiertes Phenylendiamin als Photoleiter und ein polymeres halogeniertes Arylacrylatbindemittelharz, wie Poly(p-chlorphenylacrylat), enthält. Eine solche Photoleiterschicht ist schon deswegen nicht einsetzbar, weil sich das anwesende Bindemittel nicht nach den elektrophotographischen Prozeßstufen mit einem wäßrigalkalischen Entschichter an den nicht von Toner bedeckten Stellen entfernen läßt. Auch die Forderungen nach Flexibilität, Laminierbarkeit, Rollbarkeit, Haftfähigkeit auf einem Zwischenträger oder dem Schichtträger, oder Übertragbarkeit von Zwischenträger in der Wärme und rückstandslose Entfernung des Zwischenträgers bei Raumtemperatur werden von dieser Photoleiterschicht nicht ausreichend erfüllt.

Es zeigte sich, daß, während die bekannten Bindemittel bzw. Schichten zur Herstellung von Druckplatten und gedruckten Schaltungen auf starrem Träger gut geeignet sind, dies dann weniger der Fall ist, wenn der Träger elastisch oder flexibel ist und relativ größere Schichtdicken gefordert werden.

Es war deshalb Aufgabe der Erfindung für ein weniger Energie benötigendes reprographisches Verfahren, wie das elektrophotographische, eine flexible und laminierbare Schicht zu entwickeln, welche zur Herstellung von Leiterplatten, kopierten Schaltungen bzw. geätzten Formteilen geeignet ist und bei hoher Lichtempfindlichkeit und relativ dicker Schicht die erforderliche Flexibilität besitzt, so daß sie sich auf flexiblem Träger, wie einer gegebenenfalls metallisierten oder nicht metallisierten oder metallbeschichteten Polyesterfolie, bei üblicher Handhabung weder ablöst noch Risse bildet. Dabei soll sich die Schicht in einem thermischen Laminierprozeß leicht und vollständig von dem flexiblen Zwischenträger ablösen und übertragen lassen auf einen Träger mit wenigstens einer metallischen Oberfläche und dort gut haften. Außerdem war auch für das vollständige und beschädigungsfreie Ablösen des Zwischenträgers nach der Übertragung auf den zweiten Träger zu sorgen.

Diese Aufgabe wird durch eine flexible, laminierbare lichtempfindliche Schicht der eingangs genannten Art gelöst, die dadurch gekennzeichnet ist, daß sie eine Photoleiterschicht aus im wesentlichen organischem Photoleiter, Bindemittel und Sensibilisator und/oder Aktivator darstellt, die als Bindemittel ein Mischpolymerisat aus Alkylmethacrylat mit sechs Kohlenstoffatomen in der Alkylgruppe und Acrylsäure in Kombination mit mindestens einem der Monomeren Styrol, Vinylacetat und Methacrylsäure mit einer Säurezahl im Bereich von 90 bis 250 enthält. In bevorzugter Ausführungsform enthält die Schicht ein Mischpolymerisat aus Alkylmethacrylat mit 6 Kohlenstoffatomen in der Alkyl-

2

gruppe, Styrol, Methacryl- und Acrylsäure. Vorzugsweise besitzt das Mischpolymerisat eine Säurezahl von 100 bis 230 und bei 20 °C in Ethanol/Toluol, im Gewichtsverhältnis 1 : 1, eine Grenzviskosität von 0,100 bis 0,300.

Hierdurch wird erreicht, daß eine flexible isolierende organische Photoleiterschicht zur Verfügung gestellt wird, die sich mit besonderem Vorteil zur Herstellung von Ätzschutzschichten oder Galvanoschutzschichten auf Trägern aus Metall oder mit metallischen Oberflächen, vorzugsweise Kupfer, eignet. Vor allem ist sie hervorragend zur Übertragung durch thermisches Laminieren auf Träger, wie Kupferfolien oder Folien aus anderen Metallen, wie Magnesium, Aluminium, Zink, Nickel, Chrom, Messing oder Stahl, geeignet, wie sie üblicherweise zur Herstellung von kopierten Schaltungen oder von in der Elektronik-Industrie gebräuchlichen geätzten Formteilen verwendet werden.

Die erfindungsgemäße Photoleiterschicht läßt sich besonders gut in Form sogenannter Trockenresistmaterialien einsetzen und handhaben, da sie sich gut zu haftenden Schichten auf Metallträger übertragen läßt. In diesem Fall ist als flexibler Zwischenträger besonders Polyesterfolie, vorzugsweise aus Polyethylenterephthalat, geeignet.

Die erfindungsgemäße Schicht wird durch den thermischen Laminierprozess in ihrer Quellbarkeit oder Löslichkeit in den in der Praxis verwendeten wäßrig-alkalischen Entschichterlösungen nicht nachteilig beeinflußt.

Das erfindungsgemäße Bindemittel läßt sich durch Einstellen der Art und der Mengenverhältnisse seiner Komponenten, der Säurezahl und spezifischen Viskosität in seiner Flexibilität sowie in der Übertragbarkeit und Haftung in einem weiten Bereich allen Anforderungen der Praxis anpassen.

Insbesondere wird die Säurezahl des Bindemittels so eingestellt, daß die wäßrig-alkalische Entschichterlösung während der üblichen Entschichtungszeit von 60 bis 120 Sekunden nicht auch die Flanken der nach der Entwicklung mit Toner bedeckten Teile der Photoleiterschicht angreift, wodurch die Entschichterlösung unter die Ränder der Bildzeichen und feinen Linien eindringen kann und größere Bereiche der aus Metall bestehenden Trägerschicht freilegt, als bei dem anschließenden Ätzprozeß abgetragen werden sollen. Hierfür hat sich als besonders nützlich erwiesen, die Säurezahl des Mischpolymerisates zwischen 150 und 200 einzustellen.

Während es für die Entschichtbarkeit in wäßrig-alkalischen Lösungen einerseits erforderlich ist, daß die erfindungsgemäßen Bindemittel einen ausreichenden Säurecharakter besitzen, nimmt andererseits die Sprödigkeit der Schichten mit steigender Schichtdicke und mit steigender Säurezahl zu.

Es wurde gefunden, daß durch Abstimmung des Verhältnisses der acidifizierenden und der plastifizierenden Monomeren sowie der Molekulargröße der Polymerisate erfindungsgemäß geeignete Bindemittel erhalten werden.

Nimmt man als Kriterium für die durchschnittliche Molekulargröße den Wert der Grenzviskosität $[\eta]$, dann ist ein solches Mischpolymerisat besonders geeignet, dessen Grenzviskosität, gemessen in einem Gemisch von 1 Gewichtsteil Toluol und 1 Gewichtsteil Ethanol bei 20 °C, Werte zwischen 0,100 und 0,300 aufweist mit

$$[\eta] = \lim_{c \to 0} \frac{\eta \text{ spez.}}{c}$$

wobei $\eta_{spez.}$ die spezifische Viskosität und c die Konzentration des gelösten Polymers, gemessen in Gramm Polymer pro 100 ml Lösungsmittel, bedeuten.

Im Gegensatz zu Photoleiterschichten für elektrophotographische Druckformen etc. müssen erfindungsgemäße Photoleiterschichten für kopierte Schaltungen und geätzte Formteile durch die Vielzahl der zu Herstellung erforderlichen Prozeßschritte weitere strenge Kriterien erfüllen.

Die Schichten sind relativ dick mit Schichtdicken entprechend einer Auflage von etwa 15-30 g/m². Es wurde erkannt, daß durch die Erhöhung der bisher üblicherweise verwendeten Schichtstärke von etwa 5 µm die elektrophotographische Empfindlichkeit beträchtlich herabgesetzt wird, so daß die Verwendbarkeit bekannter isolierender organischer Photoleiterschichten für Leiterplatten in den geforderten Schichtstärken nicht ohne weiteres möglich war. Der Verlust an Empfindlichkeit äußert sich in einer zu geringen Differenz der Ladung zwischen belichteten und unbelichteten Stellen auf der Oberfläche der Photoleiterschicht und in hoher Restladung auf den belichteten Teilen der Schicht. Eine Erhöhung der Strahlungsleistung der Lichtquelle oder eine Verlängerung der Belichtungszeit war aus Gründen der Praktibilität ausgeschlossen. Überraschenderweise läßt sich die Empfindlichkeit ca. 20 µm dicker Schichten dadurch angleichen, daß man die Menge an Sensibilisierungsfarbstoff beträchtlich reduziert und damit die Lichtabsorption in der dickeren Schicht verringert. Es werden deshalb Photoleiterschichten eingesetzt, welche ein Gewichtsverhältnis organischer Photoleiter zu gelöstem Sensibilisator im Bereich von etwa 80 : 1 bis 1 000 : 1 besitzen. Die Forderung nach dickeren Schichten resultiert aus dem Fertigungsprozeß kopierter Schaltungen, wenn nach dem Metallresist-Verfahren gearbeitet werden soll, wo die Kopierschicht beim nachgeschalteten galvanischen Auftragen von Kupfer und Zinn-Blei oder Nickel das durch den Entwicklungsschritt nicht freigelegte Metall schützen soll. Die erfindungsgemäße Photoleiterschicht, die zusätzlich mit der Tonerschicht bedeckt ist, dient dabei als Galvanoschutzschicht oder Galvanoresist. Die galvanisch aufgetragenen Metallschichten sollen außerdem möglichst keine pilzartigen Überhänge bilden ; dies vermeidet man dadurch, daß man die Dicke der elektrophotographi-

schen Schicht entsprechend einstellt. Die erfindungsgemäßen Bindemittel müssen schließlich zusätzlich gegen die bei der Abscheidung von Kupfer, Nickel, Blei-Zinn oder Gold verwendeten Bäder, die pH-Werte von unter 1 bis 4 besitzen, resistent sein.

Wenn nach dem in der Leiterplattenfertigung eingeführten Substraktiv-Verfahren gearbeitet wird, muß die nach dem Entwickeln mit wäßrig-alkalischen Lösungen übriggebliebene Photoleiterschicht das von ihr bedeckte Kupfer vor dem Angriff der Ätzlösungen schützen und dient damit als Ätzschutzschicht oder als Ätzresist. Es läßt sich im allgemeinen nicht vermeiden, daß das Ätzmittel im Verlauf der Ätzung auch unter den Rändern der Schicht angreift, daß also eine Unterätzung stattfindet, bei der vom Metallträger nicht mehr gestützte Überhänge, auch Resistüberhänge genannt, entstehen. Diese Überhänge sind mechanisch besonders empfindlich und können z. B. beim Sprühätzen leicht abbrechen. Dadurch erhält das Ätzmittel Zutritt zu neuen Teilen der Trägeroberfläche. Auch für diesen Anwendungszweck hat es sich als nachteilig erwiesen, wenn das Bindemittel spröde ist und unter den geschilderten Bedingungen leicht abbricht. Als Ätzmittel für Kupferträger werden sowohl stark salzsaure Lösungen von Eisen(III)chlorid als auch ammoniakalische Kupferammoniumchlorid-Lösungen mit einem pH-Wert bis 8,5 verwendet. Als Ätzmittel für Aluminiumträger können schwach salzsaure Lösungen von Kupfer(II)-chlorid benutzt werden. Demzufolge müssen die Schichten und die darin enthaltenen Bindemittel auch dieser Einwirkung standhalten. Bindemittel mit großer Säurezahl werden daher von alkalischen Ätzbädern leichter angegriffen als solche mit einer angepaßten kleineren Säurezahl.

Die erfindungsgemäße flexible isolierende Photoleiterschicht wird demgemäß in einer Schichtdicke größer als 15 μm auf einen flexiblen Träger aufgebracht. Dient der Träger als Zwischenträger, so wird sie durch Wärme und leichten Andruck vollständig auf einen Träger mit wenigstens metallischer Oberfläche übertragen.

In einer bevorzugten Ausführungsform enthält die flexible isolierende Photoleiterschicht ein Mischpolymerisat aus Alkylmethacrylat mit 6 Kohlenstoffatomen in der Alkylgruppe, Styrol und Methacryl- und Acrylsäure.

Gemäß einer weiteren Ausführungsform enthält die Schicht ein Mischpolymerisat aus einem Alkylmethacrylat mit 6 Kohlenstoffatomen in der Alkylgruppe, einem Gemisch aus Methacrylsäure und Acrylsäure oder ein Mischpolymerisat aus Vinylacetat, Alkylmethacrylat mit 6 Kohlenstoffatomen in der Alkylgruppe, Styrol und Acrylsäure.

Bevorzugt liegt in dem erfindungsgemäßen Mischpolymerisat das Gewichtsverhältnis von Styrol zu Alkylmethacrylat in einem Bereich zwischen 0:1 und 1:8. Die Methacryl- und/oder Acrylsäurekomponente im Gewichtsverhältnis zur Summe der Komponenten von Alkylmethacrylat und Styrol liegt zwischen 1:1 und 1:5. In ganz besonders bevorzugter Weise liegen die Mengenverhältnisse der Komponenten bei 55-75 Gewichtsteilen (Gt) Alkylmethacrylat mit 6 Kohlenstoffatomen in der Alkylkette, 0-12 Gt Styrol und bei 15-35 Gt Methacrylsäure und/oder Acrylsäure. Durch Variation des Mengenverhältnisses von Methacrylsäure zu Acrylsäure läßt sich eine gewünschte Flexibilität des Mischpolymeren erzielen und die Haftung des Mischpolymeren auf Kupfer oder anderen Metallen während des Laminierschrittes einstellen. Das Gewichtsverhältnis zwischen Methacrylsäure und Acrylsäure kann Werte annehmen zwischen 0:1 und 2:1.

In einem weiteren Mischpolymerisat liegt das Gewichtsverhältnis von Styrol und Alkylmethacrylat zwischen 1:0,8 und 1:8 und das Gewichtsverhältnis von Styrol zu Vinylacetat zwischen 1:1 und 1:3. Die Acrylsäurekomponente verhält sich zur Summe der Komponenten von Alkylmethacrylat, Styrol und Vinylacetat wie 1:2 bis 1:8.

In ganz besonders bevorzugter Weise liegen die Mengenverhältnisse von Alkylmethacrylat mit 6 Kohlenstoffatomen in der Alkylkette bei 20-65 Gt, 15-35 Gt Vinylacetat, 10-25 Gt Styrol und 10-25 Gt Acrylsäure.

Die erfindungsgemäßen isolierenden organischen Photoleiterschichten besitzen eine ausreichende Flexibilität auf flexiblem Träger, so daß sie gerollt oder gebogen werden können, ohne daß sie abblättern oder Risse zeigen.

Die Schichten lassen sich bei Temperaturen, beispielsweise Walzentemperaturen, zwischen 100 °C und 150 °C von der flexiblen Trägerfolie unter leichtem Andruck vollständig auf Metallplatten, zum Beispiel auf Kupferplatten, übertragen und zeigen nach dem Erkalten eine gute Haftung. Der erste Träger läßt sich von der Photoleiterschicht leicht und vollständig abziehen, ohne daß sie beschädigt wird.

Die erfindungsgemäßen Photoleiterschichten lassen sich nach Übertragung durch eine Coronaspannung aufladen. Sie lassen sich durch normales weißes Licht oder durch monochromatisches Licht, speziell durch das Licht einer monochromatischen Laserlichtquelle geringer Energie, bildmäßig belichten, wobei an den belichteten Stellen die Ladung von der Schicht in den geerdeten oder auf einem bestimmten Potential gehaltenen Träger abfließt.

Die erfindungsgemäßen Photoleiterschichten sind so lichtempfindlich, daß sie mit einem Argonionenlaser mit einer Energie von etwa 40-80 μJ/cm$^2$ bildmäßig belichtbar sind. Es hat sich gezeigt, daß auch eine Belichtung im Bereich von 20-50 μJ/cm$^2$ zu guten Ergebnissen führt.

Die noch Ladung tragenden Stellen der isolierenden photoleitenden Schicht nehmen triboelektrisch entgegengesetzt geladene Tonerteilchen eines flüssigen oder pulverförmigen Toners an, der nach kurzem Fixieren (2 min, 170 °C) mit der Photoleiterschicht verschmilzt und diese Bildstellen vor der Entschichterlösung schützt.

4

Die nicht von Toner bedeckten Stellen lassen sich gut bei etwa 15-30 μm dicken laminierten Schichten mit wäßrigalkalischen Entschichterlösungen entfernen, während die mit Toner bedeckten Stellen dieser Schicht nicht abgelöst werden.

Bei der Verwendung der erfindungsgemäßen Photoleiterschicht zur Herstellung von kopierten Schaltungen nach dem Substraktiv-Verfahren zeigen die Schichten eine hervorragende Resistenz gegen die üblichen Ätzmittel in einem Bereich von pH < 1 bis 8,5. Bei der Verwendung zur Herstellung von kopierten Schaltungen nach dem Metallresist-Verfahren zeigen die Schichten eine gute Resistenz gegen die üblicherweise verwendeten Kupfer-, Nickel-, Blei-Zinn und Gold-Galvanisierbäder.

Die erfindungsgemäße isolierende photoleitfähige Schicht kann in Form eines vorsensibilisierten Kopiermaterials auf einem geeigneten metallischen oder metallisierten Träger, z. B. auf Kupfer, Aluminium, Chrom, Nickel oder Stahl für die Herstellung von kopierten Schaltungen dem Verbraucher zur Verfügung gestellt werden.

Für den gleichen Anwendungszweckt kann sie aber auch als sogenanntes Trockenresistmaterial in den Handel gebracht werden. Die isolierende Photoleiterschicht befindet sich dann auf einem metallisierten oder nichtmetallisierten flexiblen Zwischenträger und wird vom Verbraucher auf das zu galvanisierende oder zu ätzende Material, z. B. auf eine Metallfolie, wie Aluminium, Chrom, Nickel oder Stahl, vorzugsweise auf eine Kupferfolie, durch Laminieren in der Wärme übertragen. Nach dem Erkalten und dem Abziehen des Zwischenträgers kann die Photoleiterschicht dann aufgeladen, belichtet, betonert, fixiert, entschichtet und ggf. galvanisiert oder geätzt werden. Als organische Photoleiter können die bekannten Verbindungen mit photoleitenden Eigenschaften verwendet werden, vorzugsweise werden Verbindungen wie 2,5-Bis-(4'-diethylaminophenyl)-oxdiazol-1,3,4 (DE-PS 10 58 836 ; DE-AS 25 26 720) oder 2-Vinyl-4-(2'-chlorphenyl)-5-(4''-diethylaminophenyl)-1,3-oxazol bzw. 2-Phenyl-4-(2'-chlorphenyl)-5-(4''-diethyl-aminophenyl)-1,3-oxazol (DE-PS 11 20 875, DE-AS 25 26 720) oder ein Kondensationsprodukt aus 3-Brompyren und Formaldehyd (DE-OS 27 26 116) eingesetzt.

Aktivatoren für organische isolierende Photoleiter sind bekannt und können z. B. der DE-AS 11 27 218 entnommen werden. Besonders geeignet sind Verbindungen wie 3,6-Dinitronaphthalin-1,8-dicarbonsäureanhydrid oder 9-Dicyanomethylen-2,7-dinitrofluoren.

Die Herstellung der isolierenden organischen Photoleiterschichten erfolgt in bekannter Weise. So kann man die Bestandteile in einem oder mehreren Lösemitteln lösen und die Lösung durch Gießen, Sprühen, Tauchen, durch Antrag mit Fließer oder Walzen etc. auf den vorgesehenen Träger als Film antragen und anschließend das Lösemittel durch Wärme vertreiben. Das Gewichtsverhältnis organischer photoleiter zu Bindemittel liegt im Bereich zwischen 2 : 3 und 3 : 2. Die flexiblen isolierenden photoleitenden Schichten werden in bekannter Weise auf ein negatives Potential von einigen Hundert Volt aufgeladen, belichtet, die elektrisch geladenen Bildbereiche mit einem flüssigen oder pulverförmigen, triboelektrisch positiv aufgeladenen Toner angefärbt, fixiert und entschichtet.

Als Entschichter sind vorzugsweise wäßrig-alkalische Lösungen von z. B. Alkaliphosphaten oder Alkalisilikaten geeignet, die im Bedarfsfall kleinere Mengen an wasserlöslichen organischen Lösemitteln enthalten können.

Die Belichtung kann mit normalem weißem Licht durch eine transparente Filmvorlage hindurch oder durch Projektion über eine Reprokamera erfolgen. Sie kann bei passend sensibilisierten Schichten auch mit monochromatischem Licht, speziell mit Laserlicht, vorgenommen werden.

Ein Gerät, mit dem eine Belichtung mit Laserlicht vorgenommen werden kann, ist in EP-B-0 000 048 für die Herstellung von Druckplatten beschrieben.

Dieses Gerät ermöglicht es, vollautomatisch eine fertigentwickelte Druckplatte auf elektrophotographischem Wege herzustellen. Und zwar wird hierfür ein 1. Laser für die Abtastung der Vorlage und ein 2. Laser für das synchrone Belichten der Druckplatte verwendet. Mit Hilfe dieser Vorrichtung lassen sich auch kopierte Schaltungen und kopierte Formteile, z. B. ebene Spulen, Kondensatoren oder Zahnräder, herstellen, wenn eine geeignete, für die Wellenlänge des verwendeten Lasers sensibilisierte, isolierende photoleitende Schicht auf einem Träger aus Metall vorliegt.

Für die Belichtung wird der Laserstrahl wahlweise entweder entsprechend den Hell- oder Dunkelbereichen der Vorlage moduliert. Hierzu wird die Vorlage auf einer Abtastbühne von einem Fühlerelement abgetastet, und dessen optisches Ausgangssignal steuert über einen Photovervielfacher einen Modulator im Strahlengang des Lasers für die Belichtung.

Die Vorrichtung umfaßt ferner Einrichtungen für die Zuführung des photoleitenden Aufzeichnungsmaterials zu einer Belichtungsebene sowie Elemente zur Erzeugung eines modulierten Laserstrahls für die bildmäßige Belichtung des photoleitenden Kopiermaterials.

Die folgenden Beispiele sollen die Erfindung weiter erläutern, ohne sie hierauf zu beschränken.

Die Mengenverhältnisse sind in Gewichtsteilen (Gt) angegeben. Die Gewichtsteile der Monomeren in den Mischpolymerisaten sind die bei der Polymerisation eingesetzten Mengen.


## Beispiel 1


Eine für die Herstellung kopierter Schaltungen geeignete Lösung wird aus folgenden Bestandteilen hergestellt :

120 Gt eines Mischpolymerisats aus n-Hexyl-methacrylat, Styrol, Methacrylsäure und Acrylsäure (42 : 12 : 21 : 25 Mol-%),
80 Gt 2,5-Bis-(4'-diethylaminophenyl)-oxdiazol-1,3,4,
1 Gt Astrazonorange G (C.I. 48035),
0,1 Gt Rhodamin FB (C.I. 45170),
800 Gt Tetrahydrofuran.

Die Lösung wird mittels einer Beschichtungsmaschine, die mit einem Fließer-Antragssystem, einem Trockenkanal und einer Auf- und Abwickelvorrichtung versehen ist, auf eine 50 μm starke Polyesterfolie aufgebracht. Nach dem Trocknen beträgt das Schichtgewicht der photoleitenden Schicht 20,5 g/m². Das verwendete Bindemittel wird folgendermaßen hergestellt : In einem Dreihalskolben mit Rührer und Rückflußkühler werden unter Stickstoff bei 80 °C 1 Stunde polymerisiert :

17,9 Gt n-Hexyl-methacrylat,
3,1 Gt Styrol,
4,5 Gt Methacrylsäure,
4,5 Gt Acrylsäure, gelöst in
93,3 Gt Methyl-ethyl-keton unter Zugabe von
0,209 Gt Azo-bis-isobutyronitril.

Dann dosiert man im Verlauf von 2 Stunden in diesen Ansatz

53,6 Gt n-Hexyl-methacrylat,
9,4 Gt Styrol,
13,4 Gt Methacrylsäure,
13,6 Gt Acrylsäure, gelöst in
186,6 Gt Methyl-ethyl-keton unter Zugabe von
0,630 Gt Azo-di-isobutyronitril.

Man polymerisiert weitere 5 Stunden bei 80 °C.
Nach dem Abkühlen gießt man in die zehnfache Menge Wasser ein und trennt das ausgefallene Polymer ab. Man trocknet das Produkt im Vakuumtrockenschrank bei 60 °C.
Ausbeute : 107 g.
Das Produkt hat eine Säurezahl von 159. Die Grenzviskosität in Ethanol/Toluol (1 Gt : 1 Gt) bei 20 °C beträgt 0,242.
Diese Schicht läßt sich mit dem PC-Laminator, Type L. 50.2 der Firma PMF, Konstanz bei einer eingestellten Walzentemperatur von 130 °C vollständig von der Polyesterfolie übertragen auf eine von Oxidschichten befreite 35 μm starke Kupferfolie, die auf eine 1,5 mm starke Platte aus Phenoplast-Schichtstoff kaschiert ist. Durch eine Corona mit einem negativen Potential von 5 kV läßt sich die auf der Kupferfolie befindliche Photoleiterschicht auf eine Spannung von 650 V aufladen. Diese aufgeladene Schicht wird unter einer transparenten Vorlage oder mittels einer Reprokamera belichtet. Man erhält dadurch ein latentes Ladungsmuster an den nicht vom Licht getroffenen Stellen der Schicht. Dieses Ladungsmuster wird durch Antragen eines triboelektrisch positiv geladenen flüssigen Toners sichtbar gemacht (Eine Trockenentwicklung ist ebenso gut möglich). Die Belichtung wird vorteilhafterweise in dem in der Europäischen Patentanmeldung 0 000 48 beschriebenen Gerät mittels eines 16 mW Argonionen-Lasers bei einer Wellenlänge von 488 nm vorgenommen. Hier wird der Vorteil der erfindungsgemässen hochlichtempfindlichen Schicht besonders deutlich, weil sie sich selbst bei einem Schichtgewicht von 20,5 g/m² mit einer Energie von nur 30 μJ/cm² bildmäßig belichten läßt. Diese Energie ist um den Faktor 500 bis 1 000 kleiner als die für handelsübliche Photoresistmaterialien erforderliche. Das Sichtbarmachen des latenten Bildes erfolgt, wie beschrieben. Das Tonerbild wird durch Strahlungswärme bei 170 °C 2 Minuten lang fixiert. Die Nichtbildstellen werden mit einer wäßrig-alkalischen Lösung entschichtet, welche die folgende Zusammensetzung hat : 2,75 Gt Natriumhydroxid, 4 Gt Natriummetasilikat-Nonahydrat, 3,75 Gt n-Butylglykol, 389,5 Gt Wasser. Der pH-Wert dieser Lösung ist 10,3. Man behandelt die Platte 1-2 Minuten mit dieser Lösung, sprüht mit Wasser ab und wischt die gequollenen oder gelösten Bestandteile der nicht mit Toner bedeckten Schichtteile ab.
Das auf diese Weise erhaltene Muster dient als Ätzschutzschicht und zeigt eine gute Haftung auf der Kupferoberfläche. Die Auflösung ist besser als 10 Linien pro mm. Die von der Schicht befreiten Teile der Kupferoberfläche lassen sich in der Sprühätzmaschine der Firma Chemcut, Solingen, Type 412 G, mit einer salzsauren Eisen (III)-chlorid-Lösung (Dichte 1,452 5) bei 45 °C in 1 Minuten ätzen. Die Ätzresistenz der mit Toner bedeckten photoleitenden Schicht ist hervorragend. Die Schicht ist auch beständig gegen eine 45 °C warme, schwach alkalische Lösung von Kupferammoniumchlorid, wie sie zum Ätzen von kopierten Schaltungen aus Kupfer im Handel erhältlich ist. Der pH-Wert dieser Lösung beträgt 8,5.
Nach dem Spülen mit Wasser und dem Trocknen im Luftstrom werden die kopierten Schaltungen durch Entfernen der nicht mehr benötigten Toner- und Photoleiterschicht durch Behandeln mit Lösemitteln, wie z. B. Methylenchlorid oder Tetrahydrofuran, fertiggestellt.

## Beispiel 2

Eine weitere Photoleiterschicht wird wie folgt hergestellt :

120 Gt eines Mischpolymerisats aus n-Hexylmethacrylat, Styrol und Acrylsäure (56 : 12 : 32 Mol-%),
80 Gt 2-Phenyl-4-(2'-chlorphenyl)-5-(4''-diethylaminophneyl)-1,3-oxazol,
1 Gt Astrazonorange R (C.I. 48040),
800 Gt Tetrahydrofuran.

Aus dieser Lösung wird eine Schicht auf einer 75 μm starken Folie aus Polyäthylenterephthalat hergestellt, die ein Schichtgewicht von 20,0 g/m² aufweist.

Das eingesetzte Mischpolymerisat wird folgendermaßen hergestellt :

In einem Dreihalskolben mit Rührer und Rückflußkühler werden unter Stickstoff bei 80 °C folgende Bestandteile eine Stunde polymerisiert :

a) 21,9 Gt n-Hexyl-methacrylat,
2,9 Gt Styrol,
5,3 Gt Acrylsäure, gelöst in
100 Gt Methyl-ethyl-keton unter Zugabe von
0,3 Gt Azo-di-isobutyronitril.

Dann dosiert man im Verlauf von 2 Stunden in diesen Ansatz

65,5 Gt n-Hexyl-methacrylat,
8,5 Gt Styrol,
15,8 Gt Acrylsäure, gelöst in
180 Gt Methyl-ethyl-keton unter Zugabe von
0,9 Gt Azo-di-isobutyronitril.

Man polymerisiert weitere 5 Stunden bei 80 °C. Die Aufarbeitung geschieht wie in Beispiel 1.

Die Ausbeute beträgt 112 g. Das Produkt hat eine Säurezahl von 106, die Grenzviskosität bei 20 °C in Ethanol/Toluol (1 : 1) beträgt 0,148.

Wählt man die Mengenverhältnisse so, daß in vorstehendem Beispiel insgesamt eingesetzt werden

b) 66,1 Gt n-Hexyl-methacrylat,
13,5 Gt Styrol,
40,4 Gt Acrylsäure,

dann erhält man mit einer Ausbeute von 113 g ein Polymeres mit der Säurezahl 226 und einer Grenzviskosität bei 20 °C in Ethanol/Toluol (1 : 1) von 0,179.

Die mit den Bindemitteln nach a) oder b) hergestellten Schichten sind auf Polyesterfolie gut flexibel und lassen sich bei 130 °C vollständig laminieren.

Durch die in Beispiel 1 beschriebenen Arbeitsgänge erhält man bildmäßig differenzierte Abbildungen auf Kupfer, bei denen die freigelegte metallische Schicht durch galvanische Abscheidung von Kupfer, Zinn, Blei/Zinn, Nickel oder Gold verstärkt werden kann.

Die in Beispiel 1 und 2 beschriebenen Schichten zeigen neben der erwähnten Resistenz gegen Ätzlösungen auch eine gute Resistenz gegen die beim Galvanisieren üblicherweise verwendeten stark sauren Galvanobäder.

## Beispiel 3

Eine flexible Photoleiterschicht läßt sich auch aus folgenden Bestandteilen herstellen :

95 Gt eines Mischpolymerisats aus n-Hexylmethacrylat, Methacrylsäure und Acrylsäure (50 : 25 : 25 Mol-%),
30 Gt Poly-methyl-vinyl-ether, 50 %ig in Toluol,
95 Gt Kondensationsprodukt aus 3-Brompyren und Formaldehyd (Herstellung gemäß DE-PS 21 37 288),
10 Gt 3,6-Dinitronaphthalin-1,8-dicarbonsäure-anhydrid,
800 Gt Tetrahydrofuran.

Nach dem Vorgehen in Beispiel 1 läßt sich eine Schicht mit 19,6 g/m² Schichtgewicht auf einer Folie aus Polyethylenterephthalat herstellen.

Das verwendete Bindemittel wird folgendermaßen hergestellt :

7

In einem Dreihalskolben mit Rührer und Rückflußkühler werden folgende Bestandteile unter Stickstoffatmosphäre bei 80 °C 1 Stunde polymerisiert :

15,0 Gt n-Hexyl-methacrylat,
3,8 Gt Methacrylsäure,
3,2 Gt Acrylsäure, gelöst in
104,0 Gt Methyl-ethyl-keton unter Zugabe von
0,148 Gt Azo-di-isobutyronitril.

Dann dosiert man im Verlauf von 2 Stunden in diesen Ansatz :

45,1 Gt n-Hexyl-methacrylat,
11,3 Gt Methacrylsäure,
9,5 Gt Acrylsäure, gelöst in
208 Gt Methyl-ethyl-keton unter Zugabe von
0,445 Gt Azo-di-isobutyronitril.

Man polymerisiert weitere 5 Stunden bei 80 °C.
Die Aufarbeitung geschieht wie in Beispiel 1 beschrieben.
Die Ausbeute beträgt 115 g. Das Produkt hat eine Säurezahl von 198, die Grenzviskosität bei 20 °C in Ethanol/Toluol (1 : 1) beträgt 0,235.
Die Photoleiterschicht läßt sich bei 140 °C vollständig auf Kupferblech laminieren, und durch die in Beispiel 1 beschriebenen Arbeitsgänge läßt sich eine entsprechende Abbildung erzeugen. Die Schichten zeigen die erwähnten Vorteile wie gute Beständigkeit gegen die beim Ätzen und beim Galvanisieren verwendeten Bäder.

Beispiel 4

Eine flexible, laminierbare Schicht wird aus folgenden Bestandteilen hergestellt :

120 Gt eines Mischpolymerisats aus n-Hexylmethacrylat, Vinylacetat, Styrol und Acrylsäure (12 : 38 : 20 : 30 Mol-%),
80 Gt 2-Vinyl-4-(2'-chlorphenyl)-5-(4''-diethylaminophenyl)-1,3-oxazol,
1 Gt Astrazonorange R,
800 Gt Tetrahydrofuran.

Aus dieser Lösung stellt man wie in Beispiel 1 beschrieben eine Photoleiterschicht mit einer Auflage von 19,7 g/m² auf einer 50 µm starken Folie aus Polyethylenterephthalat her.
Das verwendete Bindemittel wird wie folgt hergestellt :
In einem Dreihalskolben mit Rührer und Rückflußkühler werden folgende Bestandteile unter Stickstoffatmosphäre bei 80 °C 1 Stunde polymerisiert :

a) 25,7 Gt n-Hexyl-methacrylat,
25,1 Gt Styrol, gelöst in
70 Gt Methyl-ethyl-keton unter Zugabe von
0,3 Gt Azo-di-isobutyronitril.

Dann dosiert man im Verlauf von 2 Stunden in diesen Ansatz

41,1 Gt Vinylacetat,
27,1 Gt Acrylsäure, gelöst in
190 Gt Methyl-ethyl-keton unter Zugabe von
0,9 Gt Azo-di-isobutyronitril.

Man polymerisiert weitere 2 Stunden und macht dann eine Zugabe von

1,2 Gt Azo-di-isobutyronitril in
20 Gt Methyl-ethyl-keton.

Nach weiteren 3 Stunden und bei 80 °C ist die Polymerisation beendet. Die Aufarbeitung wird wie in Beispiel 1 beschrieben vorgenommen. Die Ausbeute beträgt 68 g. Das Produkt hat eine Säurezahl von 179, die Grenzviskosität bei 20 °C in Ethanol/Toluol (1 : 1) beträgt 0,139.
Wählt man die Mengenverhältnisse so, daß in vorstehendem Beispiel a insgesamt eingesetzt werden :

b) 40,5 Gt n-Hexyl-methacrylat,
14,9 Gt Styrol,
38,9 Gt Vinylacetat,
25,7 Gt Acrylsäure,

dann erhält man mit einer Ausbeute von 82 g ein Polymeres mit der Säurezahl 181 und einer Grenzviskosität bei 20 °C in Ethanol/Toluol (1 : 1) von 0,150.

Die mit den Polymerisaten nach a) oder b) hergestellten flexiblen Schichten lassen sich bei 130 °C von der Polyesterfolie auf eine 40 μm starke Aluminiumfolie, die auf einer Trägerfolie aus ebenfalls Polyester aufgebracht ist, vollständig übertragen und zeigen dort gute Haftung.

Nach den Angaben in Beispiel 1 lassen sich diese Schichten aufladen, belichten, betonern, fixieren und in dem angegebenen Entschichter entschichten. Die von der Schicht befreiten Teile der Aluminiumschicht lassen sich mit einer schwach salzsauren Lösung von 15 Gramm Kupfer(II)-chlorid in 100 Gramm Wasser bei 30 °C innerhalb von 2 Minuten wegätzen.

Die Resistenz der mit Toner bedeckten photoleitenden Schicht gegen die verwendete Ätzlösung ist sehr gut.

Nach dem Spülen mit Wasser und Trocknen werden der verbleibende Toner und die Schicht durch Lösemittel entfernt. Man erhält auf diese Weise — je nach kopierter Vorlage — geätzte Formteile oder Schaltungen auf flexiblen Leiterbändern, die auch für reprographische Zwecke verwendet werden können als transparente Vorlagen mit Bildmustern hoher optischer Dichte.

**Patentansprüche**

1. Flexible, laminierbare lichtempfindliche Schicht mit einem polymeren Bindemittel auf vorzugsweise flexiblem Träger, dadurch gekennzeichnet, daß sie eine Photoleiterschicht aus im wesentlichen organischem Photoleiter, Bindemittel und Sensibilisator und/oder Aktivator darstellt, die als Bindemittel ein Mischpolymerisat aus Alkylmethacrylat mit sechs Kohlenstoffatomen in der Alkylgruppe und Acrylsäure in Kombination mit mindestens einem der Monomeren Styrol, Vinylacetat und Methacrylsäure mit einer Säurezahl im Bereich von 90 bis 250 enthält.

2. Schicht nach Anspruch 1, dadurch gekennzeichnet, daß sie ein Mischpolymerisat aus Alkylmethacrylat mit sechs Kohlenstoffatomen in der Alkylgruppe, Styrol, Methacryl- und Acrylsäure enthält.

3. Schicht nach den Ansprüchen 1 oder 2, dadurch gekennzeichnet, daß sie ein Mischpolymerisat mit einer Säurezahl im Bereich von 100 bis 230 enthält.

4. Schicht nach einem der Ansprüche 1 bis 3, dadurch gekennzeichnet, daß sie ein Mischpolymerisat enthält, das bei 20 °C in Ethanol/Toluol im Gewichtsverhältnis von 1 : 1 eine Grenzviskosität von 0,100 bis 0,300 besitzt.

5. Schicht nach einem der Ansprüche 1 bis 4, dadurch gekennzeichnet, daß sie ein Mischpolymerisat enthält, in welchem Styrol und Alkylmethacrylat in einem Gewichtsverhältnis zwischen 0 : 1 und 1 : 8 vorhanden ist.

6. Schicht nach einem der Ansprüche 1 bis 4, dadurch gekennzeichnet, daß sie ein Mischpolymerisat enthält, dessen Säure-Komponente zur Summe der Komponenten von Alkylmethacrylat und Styrol im Gewichtsverhältnis zwischen 1 : 1 und 1 : 5 liegt.

7. Schicht nach Ansprüchen 1, 3 und 4, dadurch gekennzeichnet, daß sie ein Mischpolymerisat aus Alkylmethacrylat mit 6 Kohlenstoffatomen in der Alkylgruppe, Styrol, Vinylacetat und Acrylsäure enthält.

8. Schicht nach Anspruch 7, dadurch gekennzeichnet, daß sie ein Mischpolymerisat enthält, in welchem Styrol und Alkylmethacrylat in einem Gewichtsverhältnis zwischen 1 : 0,8 und 1 : 8 vorhanden ist.

9. Schicht nach den Ansprüchen 7 oder 8, dadurch gekennzeichnet, daß sie ein Mischpolymerisat enthält, in welchem Styrol und Vinylacetat in einem Gewichtsverhältnis zwischen 1 : 1 und 1 : 3 vorhanden ist.

10. Schicht nach einem der Ansprüche 7 bis 9, dadurch gekennzeichnet, daß sie ein Mischpolymerisat enthält, dessen Acrylsäurekomponente zur Summe der Komponenten von Alkylmethacrylat, Styrol und Vinylacetat im Gewichtsverhältnis zwischen 1 : 2 und 1 : 8 liegt.

11. Schicht nach einem der Ansprüche 7 bis 10, dadurch gekennzeichnet, daß sie ein Mischpolymerisat mit einer Säurezahl im Bereich zwischen 150 und 200 enthält.

12. Schicht nach einem der Ansprüche 1 bis 11, dadurch gekennzeichnet, daß das Gewischtsverhältnis organischer Photoleiter zu Bindemittel im Bereich zwischen 2 : 3 und 3 : 2 liegt.

13. Schicht nach einem der Ansprüche 1 bis 12, dadurch gekennzeichnet, daß sie eine Dicke entsprechend einer Auflage im Bereich von etwa 15 bis 30 g/m² besitztz.

14. Schicht nach einem der Ansprüche 1 bis 13, dadurch gekennzeichnet, daß sie mit einem Argonionenlaser mit einer Energie von etwa 40-80 μJ/cm² belichtbar ist.

15. Schicht nach einem der Ansprüche 1 bis 13, dadurch gekennzeichnet, daß der flexible Träger eine Kunstoffolie ist.

16. Schicht nach einem der Ansprüche 1 bis 14, dadurch gekennzeichnet, daß sie sich auf einem Träger aus Kupfer befindet.

17. Verwendung der flexiblen, laminierbaren lichtempfindlichen Schicht nach einem der Ansprüche 1 bis 16 zur Herstellung von Leiterplatten oder Leiterbändern und geätzten Formteilen.

## Claims

1. A flexible photosensitive layer capable of being laminated and containing a polymeric binder, which is applied to a preferably flexible support, characterized in that it represents a photoconductor layer composed of a substantially organic photoconductor, a binder and a sensitizer and/or activator, whereby the binder comprises a copolymer of alkyl methacrylate having six carbon atoms in its alkyl groups and acrylic acid, in combination with at least one of the monomers styrene, vinyl acetate and methacrylic acid, of an acid number in the range from 90 to 250.

2. A layer as claimed in claim 1, wherein a copolymer of an alkyl methacrylate having 6 carbon atoms in the alkyl group, styrene, methacrylic acid and acrylic acid are contained.

3. A layer as claimed in claim 1 or 2, wherein a copolymer having an acid number in the range from 100 to 230 is contained.

4. A layer as claimed in any of claims 1 to 3, wherein a copolymer is contained which has, at 20 °C in ethanol/toluene in a proportion by weight of 1 : 1, an intrinsic viscosity ranging from 0.100 to 0.300.

5. A layer as claimed in any of claims 1 to 4, wherein a copolymer is contained, in which styrene and alkyl methacrylate are present in a proportion by weight between 0 : 1 and 1 : 8.

6. A layer as claimed in any of claims 1 to 4, wherein a copolymer is contained in which the proportion by weight between its acid component and the sum of the components of alkyl methacrylate and styrene ranges between 1 : 1 and 1 : 5.

7. A layer as claimed in claims 1, 3 and 4, wherein a copolymer of an alkyl methacrylate having 6 carbon atoms in the alkyl group, styrene, vinyl acetate and acrylic acid are contained.

8. A layer as claimed in claim 7, wherein a copolymer is contained, in which styrene and alkyl methacrylate are present in a proportion by weight ranging between 1 : 0.8 and 1 : 8.

9. A layer as claimed in claim 7 or 8, wherein a copolymer is contained, in which styrene and vinyl acetate are present in a proportion by weight ranging between 1 : 1 and 1 : 3.

10. A layer as claimed in any of claims 7 to 9, wherein a copolymer is contained, in which the proportion by weight between the acrylic acid component and the sum of the components of alkyl methacrylate, styrene and vinyl acetate ranges between 1 : 2 and 1 : 8.

11. A layer as claimed in any of claims 7 to 10, wherein a copolymer having an acid number in the range between 150 and 200 is contained.

12. A layer as claimed in any of claims 1 to 11, wherein the proportion by weight of organic photoconductor to binder is in the range between 2 : 3 and 3 : 2.

13. A layer as claimed in any of claims 1 to 12, wherein the thickness of the layer corresponds to a coating weight in the range from about 15 to 30 g/m$^2$.

14. A layer as claimed in any of claims 1 to 13, which is capable of being imagewise exposed by means of an argon-ion laser operating at an energy of about 40 to 80 $\mu$J/cm$^2$.

15. A layer as claimed in any of claims 1 to 13, wherein the flexible support comprises a plastic film.

16. A layer as claimed in any of claims 1 to 14, which is applied to a support comprising copper.

17. Use of the flexible photosensitive layer which is capable of being laminated, as claimed in any of claims 1 to 16, for the production of printed circuit boards or printed circuit ribbons and etched parts.

## Revendications

1. Couche sensible à la lumière, souple et stratifiable, avec un liant polymère sur un support souple de préférence, caractérisée en ce qu'elle est une couche photoconductrice constituée d'un photoconducteur essentiellement organique, d'un liant et d'un sensibilisateur et/ou d'un activateur, qui contient comme liant un copolymère de méthacrylate d'alcoyle ayant 6 atomes de carbone dans le groupe alcoyle et d'acide acrylique en combinaison avec au moins un des monomères comprenant le styrène, l'acétate de vinyle et l'acide méthacrylique, ayant un indice d'acide compris entre 90 et 250.

2. Couche selon la revendication 1, caractérisée en ce qu'elle contient un copolymère de méthacrylate d'alcoyle ayant 6 atomes de carbone dans le groupe alcoyle, de styrène, d'acide méthacrylique et d'acide acrylique.

3. Couche selon les revendications 1 ou 2, caractérisée en ce qu'elle contient un copolymère ayant un indice d'acide compris entre 100 et 230.

4. Couche selon l'une des revendications 1 à 3, caractérisée en ce qu'elle contient un polymère qui, à 20 °C dans de l'éthanol/toluène dans un rapport pondéral de 1 : 1, a une viscosté limite de 0,100 à 0,300.

5. Couche selon l'une des revendications 1 à 4, caractérisée en ce qu'elle contient un copolymère dans lequel le styrène et le méthacrylate d'alcoyle sont présents dans un rapport pondéral compris entre 0 : 1 et 1 : 8.

6. Couche selon l'une des revendications 1 à 4, caractérisée en ce qu'elle contient un copolymère dans lequel le rapport pondéral du constituant acide à la somme des constituants méthacrylate d'alcoyle et styrène est compris entre 1 : 1 et 1 : 5.

7. Couche selon les revendications 1, 3 et 4, caractérisée en ce qu'elle contient un copolymère de méthacrylate d'alcoyle ayant 6 atomes de carbone dans le groupe alcoyle, de styrène, d'acétate de vinyle et d'acide acrylique.

8. Couche selon la revendication 7, caractérisée en ce qu'elle contient un copolymère dans lequel le styrène et le méthacrylate d'alcoyle sont dans un rapport pondéral compris entre 1 : 0,8 et 1 : 8.

9. Couche selon les revendications 7 ou 8, caractérisée en ce qu'elle contient un copolymère dans lequel le styrène et l'acétate de vinyle sont dans un rapport pondéral compris entre 1 : 1 et 1 : 3.

10. Couche selon l'une des revendications 7 à 9, caractérisée en ce qu'elle contient un copolymère dont le rapport pondéral du constituant acide acrylique à la somme des constituants méthacrylate d'alcoyle, styrène et acétate de vinyle est compris entre 1 : 2 et 1 : 8.

11. Couche selon l'une des revendications 7 à 10, caractérisée en ce qu'elle contient un copolymère ayant un indice d'acide compris entre 150 et 200.

12. Couche selon l'une des revendications 1 à 11, caractérisée en ce que le rapport pondéral du photoconducteur organique au liant est compris entre 2 : 3 et 3 : 2.

13. Couche selon l'une des revendications 1 à 12, caractérisée en ce qu'elle a une épaisseur correspondant à un poids de couche d'environ 15 à 30 g/m².

14. Couche selon l'une des revendications 1 à 13, caractérisée en ce qu'elle peut être exposée selon une image avec un laser d'ions argon ayant une énergie d'environ 40 à 80 µJ/m².

15. Couche selon l'une des revendications 1 à 13, caractérisée en ce que le support souple est une feuille de matière plastique.

16. Couche selon l'une des revendications 1 à 14, caractérisée en ce qu'elle se trouve sur un support en cuivre.

17. Utilisation de la couche sensible à la lumière, souple et stratifiable selon l'une des revendications 1 à 16, pour la production de plaques à circuit imprimé ou de bandes à circuit imprimé et de pièces gravées.